# EUROPÄISCHE PATENTSCHRIFT

(11) **EP 0 915 344 B1**
(45) Veröffentlichungstag und Bekanntmachung des Hinweises auf die Patenterteilung: **25.02.2004**
(21) Anmeldenummer: 98120166.8
(22) Anmeldetag: 28.10.1998
(51) Int. Cl.: G01R 1/073

(54) **Prüfkopf für Mikrostrukturen mit Schnittstelle**
Test head for microstructures with interface
Tête de sonde pour microstructures avec interface

(30) Priorität: 05.11.1997 DE 19748823; 10.11.1997 DE 19749456; 04.07.1998 DE 19829934
(43) Veröffentlichungstag der Anmeldung: 12.05.1999
(73) Patentinhaber: Feinmetall GmbH, 71083 Herrenberg (DE)
(72) Erfinder: Giringer, Klaus, 71083 Herrenberg (DE); Schmid, Rainer, 72124 Pliezhausen (DE); Deusch, Heinz-Ludwig, 71134 Aidlingen (DE); Gauss, Ulrich, 71083 Herrenberg (DE)
(74) Vertreter: Grosse, Rainer, Dipl.-Ing.

(56) Entgegenhaltungen:
- EP-A- 0 068 270
- EP-A- 0 571 879
- WO-A-90/06518
- FR-A- 2 535 064
- US-A- 4 423 376
- US-A- 4 931 726
- US-A- 5 451 883
- PATENT ABSTRACTS OF JAPAN vol. 1995, no. 05, 30. Juni 1995 (1995-06-30) & JP 07 050322 A (YOKOWO CO LTD;OTHERS: 02), 21. Februar 1995 (1995-02-21)

## Beschreibung

Die Erfindung betrifft einen Prüfkopf mit einer Kontaktiervorrichtung zum Kontaktieren von vorzugsweise eng nebeneinander angeordneten Prüfpunkten eines elektrischen Prüflings, gemäß Oberbegriff des Anspruchs 1.

Prüfköpfe der hier angesprochenen Art dienen zum gleichzeitigen Kontaktieren von mehreren, nebeneinander angeordneten Prüfpunkten eines elektrischen Prüflings, beispielsweise eines Halbleiterbauelements. Der Prüfkopf umfaßt mehrere stiftförmige, aus einem elastischen Material bestehende Kontaktelemente, die bei einem Prüfvorgang in Anlage mit jeweils einem zugeordneten Prüfpunkt gebracht werden. Die Kontaktelemente sind Teil einer Kontaktvorrichtung. Die Kontaktkraft wird dabei durch Ausknicken und/oder Ausfedern der Kontaktelemente senkrecht zu ihrer Längserstreckung beim Aussetzen der Kontaktelemente auf die Prüfpunkte beziehungsweise der Prüfpunkte auf die Kontaktelemente aufgebracht. Die Kontaktelemente sind in Durchgangsöffnungen von zwei voneinander beabstandeten Führungsplatten angeordnet. Aufgrund ihrer Funktion müssen die Kontaktelemente in den Durchgangsöffnungen der Führungsplatten axial beweglich gelagert sein. Um zu verhindern, daß die Kontaktelemente in Bereitschaftsstellung des Prüfkopfs, also beispielsweise zwischen zwei Prüfvorgängen, aus den Durchgangsöffnungen -der Schwerkraft folgend- herausfallen, ist aus der DE 23 64 786 bekannt, im Endbereich eines Kontaktelements einen Abstützkopf anzubringen, dessen Außenmaße größer sind als die lichte Weite der Durchgangsöffnungen. Auf der dem Prüfling abgewandten Seite der oberen Führungsplatte ist ein die Durchgangsöffnungen abdeckendes Gegenlager vorgesehen, mit dessen Hilfe verhindert wird, daß die Kontaktelemente aus den Durchgangsöffnungen herausfallen, wenn der Prüfkopf umgedreht wird. Das Gegenlager ist unlösbar mit der Kontaktiervorrichtung verbunden, wodurch ein Austausch der Kontaktelemente - wenn überhaupt- nur mit großem Aufwand möglich ist, da hierzu das Gegenlager von der Kontaktiervorrichtung abgenommen und die die beiden Teile aneinander haltenden Befestigungsmittel zerstört werden müssen. Durch den relativ großen Abstand der Kontaktelemente zueinander können auf engstem Raum angeordnete, kleine Prüfpunkte, wie sie beispielsweise bei Prüflingen aus der Halbleitertechnik häufig vorkommen, nicht mehr kontaktiert werden.

Aus der FR 2 535 064 und EP0068270 ist bekannt, Kontaktelemente durch zwei Führungsplatten zu führen und zwischen den Führungsplatten zu isolieren. Dies hat zur Folge, daß die Kontaktelemente zwar nicht herausfallen können, aber auch nicht einfach ausgetauscht werden können.

Es ist daher Aufgabe der Erfindung, einen Prüfkopf zu schaffen, bei dem die Kontaktelemente eng nebeneinander angeordnet werden können und einfach austauschbar sind.

Zur Lösung der genannten Aufgabe wird ein Prüfkopf mit den Merkmalen des Anspruchs 1 vorgeschlagen. Dieser zeichnet sich dadurch aus, daß die Kontaktelemente mit Hilfe von Haltemitteln gegen Herausfallen aus den Durchgangsöffnungen gesichert sind, und daß das Verbindungselement und die Kontaktiervorrichtung mittels Befestigungsmitteln lösbar miteinander verbunden sind. Dadurch ist eine Trennung des Verbindungselements von der Kontaktiervorrichtung beziehungsweise umgekehrt möglich, so daß eines der beiden Teile ohne weiteres austauschbar ist. Des weiteren ergibt sich durch die Trennung des Verbindungselements und der Kontaktiervorrichtung eine gute Zugänglichkeit der Kontaktelemente von der dem Verbindungselement zugewandten Seite der Kontaktiervorrichtung für Wartungs- und Reparaturarbeiten. Ferner ist es möglich, daß das Verbindungselement, das Teil einer Prüfeinrichtung ist, für unterschiedliche Kontaktiervorrichtungen verwendbar ist, wodurch sich eine universelle Einsetzbarkeit ergibt. Die "unterschiedlichen" Kontaktiervorrichtungen können einen im wesentlichen identischen Aufbau aufweisen und unterscheiden sich insbesondere in der Rasteranordnung der Kontaktelemente, die an die Anordnung der Prüfpunkte eines bestimmten Prüflings angepaßt ist, und/oder der Anzahl der Kontaktelemente. Das Verbindungselement ist also universell für verschiedene Prüflinge einsetzbar. Damit die in den Durchgangsöffnungen axial verschieblich angeordneten Kontaktelemente in einer Bereitschaftsstellung, beispielsweise zwischen zwei Prüfvorgängen, nicht aus den Durchgangsöffnungen herausgleiten können, sind Haltemittel vorgesehen, die die Kontaktelemente gegen ein Verlieren sichern.

Die aus einem elektrisch leitenden Material bestehenden Kontaktelemente weisen einen ersten, durchmessergrößeren Abschnitt und einen sich daran anschließenden zweiten, durchmesserkleineren Abschnitt auf, wobei die Durchmesserdifferenz durch eine elektrisch isolierende Schicht im Bereich des ersten Abschnitts bewirkt ist. Die isolierende Schicht dient einerseits dazu, bei Berührung der Kontaktelemente, von denen zumindest ein Teil während eines Prüfvorgangs senkrecht zu deren Längserstreckung ausgelenkt werden, einen elektrischen Kontakt zu verhindern. Andererseits können mit Hilfe der Isolierschicht die Kontaktelemente in der Kontaktiervorrichtung gehalten, also gegen ein Verlieren gesichert werden.

Die Kontaktelemente mit ihrem zweiten, durchmesserkleineren Abschnitt in der jeweils zugeordneten Durchgangsöffnung der Führung axial verschieblich geführt, wobei der Durchmesser der Durchgangsöffnung kleiner ist als der Außendurchmesser des ersten, durchmessergrößeren Abschnitts. Durch den Durchmesserunterschied zwischen dem ersten und dem zweiten Abschnitt wird eine Stufe, Kante oder dergleichen am Kontaktelement gebildet, die an einer Fläche, Kante oder dergleichen der Führung anliegt und somit das Herausfallen des Kontaktelements aufgrund seines Eigengewichts verhindert. Aufgrund dessen kann ein relativ großes Spiel zwischen dem zweiten Abschnitt der Kontaktelemente und den Durchgangsöffnungen realisiert werden, so daß die Herstellungskosten nur relativ klein sind.

Nach einer ersten Ausführungsvariante wird der Durchmesserübergang, also die Durchmesserdifferenz zwischen dem ersten und dem zweiten Abschnitt der Kontaktelemente durch Abisolieren des zweiten Abschnitts gebildet. Für die Herstellung der Kontaktelemente ergibt sich daraus, daß diese zunächst in einem ersten Arbeitsgang mit der Isolierschicht versehen werden und in einem weiteren, zweiten Arbeitsgang eine gewünschte Länge der beiden Abschnitte durch Entfernen der Schicht im Bereich des zweiten Abschnitts eingestellt werden. Nach einer weiteren Ausführungsvariante ist der Durchmesserübergang durch das Aufbringen einer elektrischen Isolierung im Bereich des ersten Abschnitts bewirkt. Die Herstellung des Durchmesserunterschieds zwischen dem ersten und dem zweiten Abschnitt der Kontaktelemente wird hierbei insofern vereinfacht, da nur ein einziger Arbeitsschritt notwendig ist. Dieser besteht darin, beispielsweise durch ein definiertes Eintauchen der Kontaktelemente in die verflüssigte Isolierung exakt den ersten Abschnitt mit der Isolierung mit einer gewünschten Schichtdicke zu versehen. Selbstverständlich kann das Aufbringen der Isolierung ausschließlich auf den ersten Abschnitt der Kontaktelemente auch mit anderen bekannten Herstellungsverfahren realisiert werden.

Des weiteren wird ein Ausführungsbeispiel des Prüfkopfs bevorzugt, das sich dadurch auszeichnet, daß die Führung mindestens zwei mit Durchgangsöffnungen für die Kontaktelemente versehene Führungsplatten umfaßt, wobei die jeweils einem Kontaktelement zugeordneten Durchgangsöffnungen der Führungsplatten derart versetzt zueinander angeordnet sind, daß das Kontaktelement in ihnen und oder mindestens einer von ihnen reibschlüssig gehalten ist. Die durch den Reibschluß zwischen der beziehungsweise den Durchgangsöffnungen und dem darin angeordneten Kontaktelement auf dieses wirkende Haltekräfte sind derart hoch, daß in einer Bereitschaftsstellung des Prüfkopfs, also wenn die Kontaktelemente nicht an den Prüfpunkten eines Prüflings anliegen, die Kontaktelemente in der beziehungsweise in den Durchgangsöffnungen gehalten wird. Ein Herausfallen der Kontaktelemente aus dem Prüfkopf aufgrund ihres Eigengewichts wird somit sicher verhindert. Die durch den Reibschluß auf die Kontaktelemente wirkenden Haltekräfte sind gleichzeitig aber auch so gering, daß bei einem Prüfvorgang die Kontaktelemente in axialer Richtung verlagert werden können. Dabei knicken und/oder federn die Kontaktelemente in dem Zwischenraum zwischen den Führungsplatten senkrecht oder im wesentlichen senkrecht zu ihrer Längserstreckung aus, wodurch die Kontaktkraft aufgebracht wird. Die Kontaktelemente des Prüfkopfs können eng, also in einem vorzugsweise sehr geringen Abstand nebeneinander angeordnet werden, so daß auch Prüflinge auf Funktion geprüft werden können, deren Prüfpunkte klein und auf engstem Raum angeordnet sind. Auf eine Vergrößerung des Durchmessers der Kontaktelemente, um diese am Prüfkopf, das heißt in den Durchgangsöffnungen der Führungsplatten zu halten, kann also verzichtet werden. Ein weiterer Vorteil, der sich durch das reibschlüssige Halten der Kontaktelemente ergibt, besteht darin, daß diese servicefreundlich montierbar sind, das heißt, sie können sowohl einfach in den Prüfkopf eingebracht als auch im Bedarfsfall ausgetauscht werden. Hierzu muß das jeweilige Kontaktelement lediglich aus den Durchgangsöffnungen der Führungsplatten herausgezogen beziehungsweise hindurchgedrückt werden.

Bei einem besonders bevorzugten Ausführungsbeispiel des Prüfkopfs ist eine dritte Führungsplatte vorgesehen, die im Zwischenraum zwischen einer ersten Führungsplatte und einer zweiten Führungsplatte der Kontaktiervorrichtung angeordnet ist, wobei mindestens eine der einem Kontaktelement zugeordneten Durchgangsöffnungen zu den anderen Durchgangsöffnungen in den anderen Führungsplatten versetzt ist. Vorzugsweise ist die Durchgangsöffnung der dritten Führungsplatte zu den Durchgangsöffnungen der ersten und zweiten Führungsplatte versetzt angeordnet, so daß die Kontaktelemente bei zusammengebautem Prüfkopf definiert vorgebogen sind. Dadurch werden einerseits die Knickkraft vollständig ausgeschaltet und andererseits der Reibschluß zwischen den Kontaktelementen und mit jeweils mindestens einer zugeordneten Durchgangsöffnung der Führungsplatten gebildet. Durch die dritte Führungsplatte wird ferner sichergestellt, daß die Kontaktelemente sich insbesondere während eines Prüfvorgangs nicht gegenseitig berühren.

Bevorzugt wird auch ein Ausführungsbeispiel des Prüfkopfs, bei dem das den Prüfpunkten zugewandte und/oder abgewandte freie Ende der Kontaktelemente eine Kontaktspitze aufweist. Dadurch können auch sehr kleine, eng nebeneinander angeordnete Prüfpunkte kontaktiert werden. Aufgrund der geringen Anlagefläche der Kontaktspitze an einem Prüfpunkt ist die sich einstellende Flächenpressung relativ groß, so daß ein guter elektrischer Kontakt gebildet wird. Nach einer ersten Ausführungsvariante ist vorgesehen, daß die stiftförmigen, vorzugsweise aus einem federelastischen Material bestehenden Kontaktelemente an einem freien Ende oder an beiden freien Enden zur Ausbildung der Kontaktspitze spitz zulaufen beziehungsweise angespitzt sind. Das jeweilige Kontaktelement und die Kontaktspitze sind also einstückig ausgebildet. Bei einem anderen Ausführungsbeispiel ist die Kontaktspitze ein separates Teil, das am freien Ende der Kontaktelemente angebracht wird. Dadurch können individuell für jeden Prüfkopf Kontaktelemente eingesetzt werden, die Kontaktspitzen mit unterschiedlichen Formen und/oder Größen aufweisen, was die Anpassungsfähigkeit des Prüfkopfs verbessert. Unabhängig von der Ausgestaltung der Kontaktspitze kann deren größter Durchmesser beziehungsweise größte Breite kleiner oder größer als der Durchmesser des Kontaktelements sein oder aber diesem entsprechen. Das heißt, der Übergang vom Kontaktelement zur Kontaktspitze ist entweder fließend und stufenlos oder aber der Übergang weist mindestens einen Absatz auf.

Schließlich wird auch ein Ausführungsbeispiel des Prüfkopfs bevorzugt, bei dem die Kontaktelemente in Durchgangsöffnungen einer Haltefolie, Elastomerschicht oder dergleichen reibschlüssig gehalten sind. Allen Ausführungsvarianten des Haltemittels für die Kontaktelemente ist gemeinsam, daß diese aus einem flexiblen und elektrisch nicht-leitenden Material bestehen. Derartige Haltemittel weisen jeweils eine Durchgangsöffnung für ein Kontaktelement auf, wobei der Durchmesser der Durchgangsöffnung kleiner, zumindest aber bereichsweise kleiner ist als der Außendurchmesser des Kontaktelements. Der dadurch gebildete Reibschluß zwischen dem Haltemittel und den Kontaktelementen ist beispielsweise so groß, daß auch während eines Prüfvorgangs eine axiale Verschiebung der Kontaktelemente in den Durchgangsöffnungen nicht möglich ist. In Abhängigkeit der elastischen Eigenschaften des Haltemittels kann während eines Prüfvorgangs das Haltemittel beziehungsweise die Bereiche des Haltemittels, die von den Kontaktelementen durchdrungen sind, in Längserstreckung der Kontaktelemente ausgelenkt werden. Nach Beendigung des Prüfvorgangs federn diese selbsttätig in ihre Ausgangsstellung zurück. Die die Kontaktelemente in den Durchgangsöffnungen haltenden Haltekräfte können aber auch so klein sein, daß während eines Prüfvorgangs die Kontaktelemente in den Durchgangsöffnungen axial verschoben werden. Allen Ausführungsbeispielen des Haltemittels ist gemeinsam, daß die Haltekräfte zumindest so groß sind, daß ein Herausgleiten der Kontaktelemente aus den Durchgangsöffnungen aufgrund ihres Eigengewichts verhindert ist.

Weitere vorteilhafte Ausführungsformen ergeben sich aus den übrigen Unteransprüchen.

Die Erfindung wird im folgenden anhand der Zeichnung näher erläutert. Es zeigen:
- Figur 1: eine Prinzipskizze eines Prüfkopfs;
- Figur 2: eine Prinzipskizze eines zweiten Prüfkopfs und
- Figuren 3 und 4: jeweils einen Ausschnitt eines Ausführungsbeispiels des erfindungsgemäßen Prüfkopfs.

Der im folgenden beschriebene Prüfkopf dient zur Prüfung elektronischer Bauelemente, deren Prüfpunkte klein und nebeneinander angeordnet sind. Der Prüfkopf ist allgemein einsetzbar, beispielsweise im Bereich der Halbleitertechnik für den elektrischen Test von Feinstleiterplatten und Halbleiterwafern.

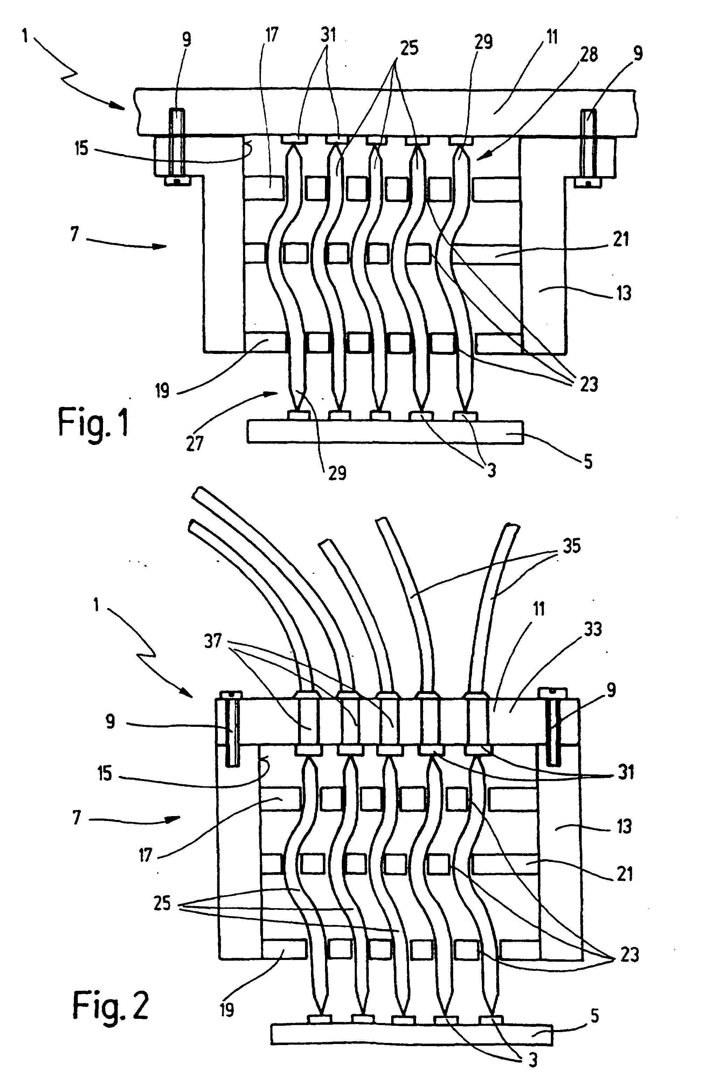

Figur 1 zeigt schematisch einen Ausschnitt eines eines Prüfkopfs 1 zum gleichzeitigen Kontaktieren von mehreren, nebeneinander angeordneten Prüfpunkten 3 eines elektrischen Prüflings 5. Der Prüfkopf 1 umfaßt eine Kontaktiervorrichtung 7, die mittels Befestigungsmittel 9 lösbar mit einem Verbindungselement 11, beispielsweise Leiterplatte, einer Prüfeinrichtung verbunden ist, die beispielsweise eine Prüfspannungsquelle oder dergleichen umfaßt. Bei diesem Beispiel sind die Befestigungsmittel 9 von mit einem Außengewinde versehenen Schrauben gebildet, von denen in der Darstellung gemäß Figur 1 lediglich zwei Schrauben dargestellt sind. Die Schrauben durchgreifen hier jeweils eine Bohrung im Grundkörper 13 des Prüfkopfs 1 und sind in nicht näher dargestellten, in dem Verbindungselement 11 eingebrachte Gewindebohrungen eingeschraubt. Die Befestigungsmittel können selbstverständlich auch als Stift-, Wellen-Naben-Verbindungen sowie von Klammern, Federn oder dergleichen gebildet werden. Wichtig ist, daß der Zusammenhalt des Verbindungselements 11 und der Kontaktiervorrichtung 7 durch eine lösbare Verbindung geschaffen ist. Das Befestigungsmittel wird also beim Trennen der beiden Teile voneinander nicht zerstört.

Die Kontaktiervorrichtung 7 umfaßt einen hülsenförmigen Grundkörper 13, der ein Durchgangsloch 15 aufweist, in dem eine erste Führungsplatte 17, eine zweite Führungsplatte 19 und eine dritte Führungsplatte 21 parallel zueinander und in einem Abstand voneinander gehalten sind. In den Führungsplatten 17, 19, 21 sind Durchgangsöffnungen 23 eingebracht, in denen stiftförmige, auch als Testsonden bezeichnete Kontaktelemente 25 axial verschieblich geführt sind. In der Ansicht des Prüfkopfs gemäß Figur 1 sind lediglich fünf Kontaktelemente dargestellt. Ein Prüfkopf der hier angesprochenen Art kann bis zu mehreren tausend Kontaktelemente umfassen. Die Kontaktelemente 25 bestehen aus einem elastischen, vorzugsweise federelastischen Material, zum Beispiel Federmetall, und sind hier als Knickdrähte ausgebildet. Die Führungsplatten 17, 19, 21 bestehen vorzugsweise aus einem elektrisch nicht-leitenden Material, beispielsweise einem Kunststoff, Glas, Keramik, Silizium oder dergleichen. Bei einem anderen, in den Figuren nicht dargestellten Beispiel umfaßt die Führung für die Kontaktelemente anstelle oder zusätzlich zu den Führungsplatten Führungselemente, deren Dicke größer ist als die Dicke der Führungsplatten.

Wie aus Figur 1 ersichtlich, sind die jeweils einem Kontaktelement 25 zugeordneten Durchgangsöffnungen 23 der ersten und zweiten Führungsplatte 17 beziehungsweise 19 fluchtend miteinander angeordnet. Die zugeordnete Durchgangsöffnung 23 der in dem Zwischenraum zwischen der ersten und zweiten Führungsplatte angeordneten dritten Führungsplatte 21 ist zu den Durchgangsöffnungen 23 der Führungsplatten 17, 19 versetzt. Dadurch weisen die in den Durchgangsöffnungen 23 angeordneten Kontaktelemente 25 einen Bogen beziehungsweise eine gebogene Form auf. Durch das Auslenken der Kontaktelemente 25 senkrecht zu deren Längserstreckung wird ein Reibschluß zwischen den Kontaktelementen 25 und mindestens einer der zugeordneten Durchgangsöffnungen 23 der Führungsplatten 17, 19, 21 gebildet. Die Kontaktelemente 25 werden ausschließlich durch Reibung im Grundkörper 13 der Kontaktiervorrichtung 7 gehalten. Ein Herausfallen beziehungsweise Herausgleiten der Kontaktelemente 25 aus den Durchgangsöffnungen 23 wird somit sicher verhindert.

Die Kontaktelemente 25 weisen an ihrem den Prüfpunkten 3 des Prüflings 5 zugewandten freien Ende 27 und an ihrem dem Verbindungselement 11 zugewandten freien Ende 28 jeweils eine Kontaktspitze 29 auf, die hier durch Anspitzen der stiftförmigen Kontaktelemente 25 gebildet wird. Die Kontaktelemente 25 sind mit ihrem den Prüfpunkten 3 abgewandten freien Ende 28 an jeweils eine zugeordnete Kontaktstelle 31 andrückbar, die bei dem in Figur 1 dargestellten Beispiel auf dem Verbindungselement 11 der Prüfeinrichtung angebracht sind. Das freie Ende 27 der Kontaktelemente 25 ist an jeweils einen zugeordneten Prüfpunkt 3 des Prüflings 5 andrückbar.

Im folgenden wird die Funktion des Prüfkopfs 1 anhand eines Prüfvorgangs näher erläutert: In der in Figur 1 dargestellten Funktionsstellung der Kontaktiervorrichtung 7 berühren die Kontaktelemente 25 sowohl die Prüfpunkte 3 des Prüflings 5 als auch die Kontaktstellen 31 auf dem Verbindungselement 11. Durch eine Relativbewegung zwischen der Kontaktiervorrichtung 7 und dem Prüfling 5 werden die Kontaktelemente 25 in den Durchgangsöffnungen 23 der Führungsplatten 19 und 21 axial verlagert. Durch die Druckbeaufschlagung der stiftförmigen Kontaktelemente 25 in Längsrichtung werden die durch die versetzte Anordnung der Durchgangsöffnungen der dritten Führungsplatte 21 bereits vorgebogenen Kontaktelemente 25 ausgelenkt. Die durch die elastischen Eigenschaften des Materials der Kontaktelemente erzeugten Rückstellkräfte pressen dabei die Kontaktelemente 25 mit ihren Kontaktspitzen 29 definiert an die Prüfpunkte 3 des Prüflings 5 und an die Kontaktstellen 31 des Verbindungselements 11, wodurch ein geringer elektrischer Kontaktwiderstand erzielt wird. Die Prüfpunkte 3 können nun auf Durchgang und Isolation gegeneinander hin beziehungsweise der Prüfling 5 auf Funktion überprüft werden. Nachdem der Prüfvorgang abgeschlossen ist, werden die Kontaktiervorrichtung 7 und der Prüfling 5 voneinander getrennt. Die ausgelenkten/durchgebogenen Kontaktelemente 25 verlagern sich nun aufgrund ihrer elastischen Eigenschaften selbsttätig in ihre Ausgangsstellung zurück.

Es wird deutlich, daß die Kontaktstellen 31 auf dem Verbindungselement 11 als Widerlager für die Kontaktelemente 25 dienen.

Es ist bei einem -in den Figuren nicht dargestellten- Beispiel des Prüfkopfs vorgesehen, daß die Kontaktelemente 25 in Bereitschaftsstellung des Prüfkopfs 1 zu den Kontaktstellen 31 beabstandet angeordnet sind. Dadurch werden beim Kontaktieren der Prüfpunkte die Kontaktelemente 25 zunächst soweit axial verlagert, bis diese an den Kontaktstellen 31 anliegen. Erst dann können die Kontaktelemente 25 weiter durchgebogen und somit die Kontaktkräfte erzeugt werden, die die Kontaktspitzen 29 der Kontaktelemente 25 an den jeweiligen Prüfpunkt 3 beziehungsweise die jeweilige Kontaktstelle 31 anpressen.

Der in Figur 1 dargestellte Prüfkopf 1 zeichnet sich durch eine sehr kompakte Bauweise und eine hohe Anpassungsfähigkeit an beispielsweise verschiedene Prüflinge und/oder Prüfparameter aus.

Figur 2 zeigt schematisch ein weiteres Beispiel eines Prüfkopfs 1. Teile, die mit denen in Figur 1 übereinstimmen, sind mit gleichen Bezugszeichen versehen, daß insofern auf die Beschreibung zur Figur 1 verwiesen wird. Im folgenden soll lediglich auf die Unterschiede näher eingegangen werden.

Die Kontaktiervorrichtung 7 ist mittels der bei diesem Beispiel von Schrauben gebildeten Befestigungsmittel 9 lösbar mit einem hier von einem Anschlußkopf 33 gebildeten Verbindungselement 11 der Prüfeinrichtung verbunden, an dem die Kontaktstellen 31 angebracht sind. Die Schrauben durchgreifen hier im Anschlußkopf eingebrachte Durchgangsbohrungen und sind in im Grundkörper 13 des Prüfkopfs 1 eingebrachte Gewindebohrungen eingeschraubt. Die Kontaktstellen 31 sind jeweils mit dem freien Ende einer Leitung 35 verbunden, die über nicht dargestellte Steckverbinder oder direkt mit der Prüfeinrichtung verbunden sind. Die Leitungen 35 sind in Löcher 37 des Anschlußkopfs 33 befestigt, beispielsweise eingeklebt.

Den in den Figuren 1 und 2 dargestellten Beispielen ist gemeinsam, daß die Kontaktiervorrichtung 7 einfach durch Lösen der Befestigungsmittel 9 von den übrigen Teilen des Prüfkopfs 1 getrennt werden kann. Die Kontaktelemente 25 sind dann von beiden Öffnungen des Durchgangslochs 15 zugänglich, was einen Austausch einzelner Kontaktelemente 25 vereinfacht. Dadurch, daß die Kontaktelemente 25 lediglich reibschlüssig in wenigstens einer der Durchgangsöffnungen 23 der Führungsplatten 17, 19, 21 gehalten sind, können diese ohne weiteres aus den Durchgangsöffnungen ausgebracht und neue Kontaktelemente eingesetzt werden.

Zusammenfassend ist festzuhalten, daß der anhand der Figuren 1 und 2 beschriebene Prüfkopf 1 einen einfachen Aufbau aufweist und somit kostengünstig herstellbar ist, insbesondere deshalb, weil die Kontaktelemente lediglich reibschlüssig in den Durchgangsöffnungen der Führungsplatten beziehungsweise in der Durchgangsöffnungen einer der Führungsplatten reibschlüssig gehalten sind. Mit dem Prüfkopf können feinstrukturierte Prüflinge, deren Prüfpunkte sehr klein und in einem geringen Abstand voneinander angeordnet sind, geprüft werden, wobei mit Hilfe der angespitzten Kontaktelemente beziehungsweise der Kontaktspitzen der Kontaktelemente aufgrund der hohen Flächenpressung ein guter elektrischer Kontakt sowohl zwischen Kontaktelement und Prüfpunkt als auch Kontaktelement und Kontaktstelle erreicht werden.

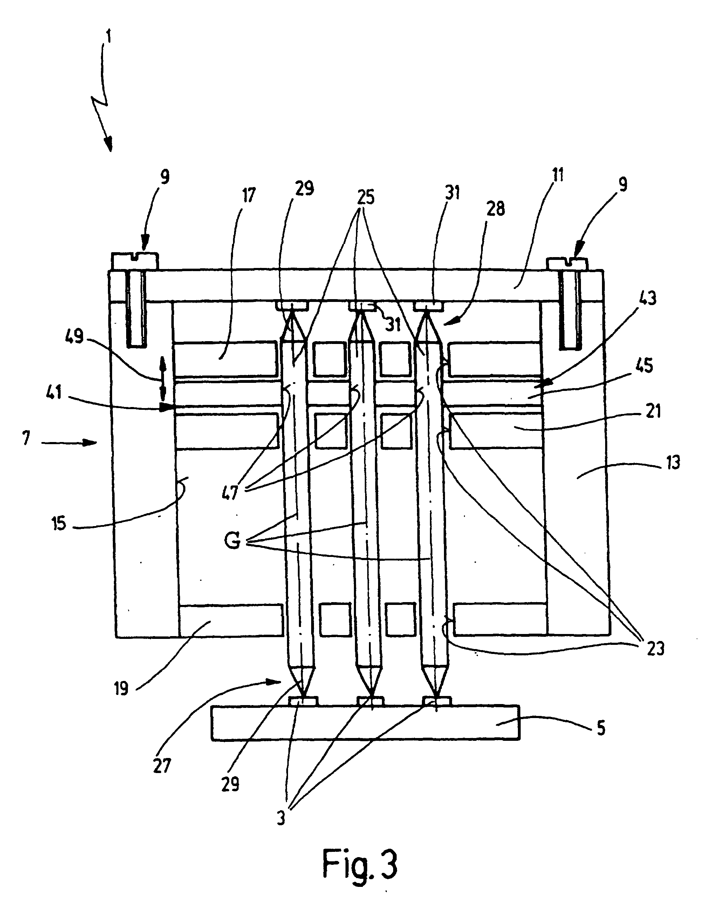

Figur 3 zeigt eine Prinzipskizze eines dritten Beispiels des Prüfkopfs. Gleiche Teile sind mit gleichen Bezugszeichen versehen, so daß insofern zur Beschreibung der vorangegangenen Figuren verwiesen wird. Im folgenden wird lediglich auf die Unterschiede näher eingegangen. Der Prüfkopf 1 umfaßt eine Führung, die -wie bei dem Ausführungsbeispiel gemäß der Figuren 1 und 2- drei in einem Abstand zueinander angeordnete Führungsplatten 17, 19, 21 umfaßt, die in einem Durchgangsloch 15 eines Grundkörpers 13 des Prüfkopfs 1 befestigt sind. In den Führungsplatten 17, 19, 21 sind Durchgangsöffnungen 23 für Kontaktelemente 25 vorgesehen, die bei diesem Ausführungsbeispiel zueinander fluchtend angeordnet sind. Das heißt, die Längsachsen der jeweils einem Kontaktelement zugeordneten Durchgangsöffnungen 23 in den Führungsplatten sind hintereinander auf einer gedachten Geraden G angeordnet, die in Figur 3 mit gestrichelter Linie dargestellt sind. In dem Zwischenraum 41 zwischen den Führungsplatten 17 und 21 ist ein Haltemittel 43 angeordnet, das bei diesem Beispiel von einer vorzugsweise aus einem flexiblen Material bestehenden Haltefolie 45 gebildet ist. In der Haltefolie 45 sind zu den Durchgangsöffnungen 23 in den Führungsplatten 17, 19, 21 fluchtend angeordnete Durchgangsöffnungen 47 eingebracht, in denen jeweils ein Kontaktelement 25 reibschlüssig gehalten ist. Das heißt, der Durchmesser der Durchgangsöffnung 47 ist zumindest abschnittsweise kleiner als der Außendurchmesser der Kontaktelemente. Die Haltefolie 45 ist zwischen den Führungsplatten 17, 21 in Richtung eines Doppelpfeils 49 frei beweglich. Aufgrund der Anordnung der Haltefolie 45 zwischen den Führungsplatten 17, 21 und dem reibschlüssigen Halten der Kontaktelemente in den Durchgangsöffnungen 47 sind die Kontaktelemente 25 gegen ein Herausgleiten beziehungsweise -fallen aus der Kontaktiervorrichtung 7 gesichert. Selbstverständlich ist es auch möglich, daß die Haltefolie 45 im Durchgangsloch 15 des Grundkörpers 13 unverschiebbar befestigt ist, so daß die eingespannte Haltefolie während eines Prüfvorgangs lediglich bereichsweise ausgelenkt oder gebogen wird.

Bei einer Variante des in Figur 3 dargestellten Beispiels des Prüfkopfs ist vorgesehen, daß die jeweils einem Kontaktelement 25 zugeordneten Durchgangsöffnungen 23 der ersten und zweiten Führungsplatte 17 beziehungsweise 19 fluchtend miteinander angeordnet sind, und daß die zugeordnete Durchgangsöffnung 23 der zwischen den Führungsplatten 17, 19 angeordneten dritten Führungsplatte 21 zu den Durchgangsöffnungen 23 der anderen Führungsplatten versetzt ist. Dadurch werden die in die Durchgangsöffnungen eingebrachten Kontaktelemente senkrecht zu deren Längserstreckung ausgelenkt, so daß diese einen Bogen aufweisen. Dadurch wird den Kontaktelementen eine Vorzugsrichtung vorgegeben, in der diese bei Druckbelastung ausgelenkt werden. Mit anderen Worten, durch einen Versatz der Führungsplatten beziehungsweise der darin eingebrachten Durchgangsöffnungen zueinander kann die bevorzugte Knickrichtung der Kontaktelemente eingestellt werden. Besonders vorteilhaft bei dieser Ausführungsvariante des Prüfkopfs ist, daß durch die gebogene Form der Kontaktelemente im montierten Zustand die für die Knickung der Kontaktelemente erforderliche Kraft vollständig ausgeschaltet ist. Es wird ohne weiteres deutlich, daß auch die Durchgangsöffnungen 47 in der Haltefolie 45 zu den Durchgangsöffnungen 23 in mindestens einer der Führungsplatten 17, 19, 21 versetzt angeordnet sein können.

Bei einem weiteren vorteilhaften Ausführungsbeispiel ist vorgesehen, daß das Haltemittel 43, also zum Beispiel die vorzugsweise aus einem flexiblen Material bestehende Haltefolie oder eine Elastomerschicht, an mindestens einer der Führungsplatten 17, 21 angebracht ist, zum Beispiel auf der dem Zwischenraum 45 zugewandten Seite der Führungsplatten. Dadurch kann die Herstellung, insbesondere die Montage des Prüfkopfs 1 vereinfacht werden.

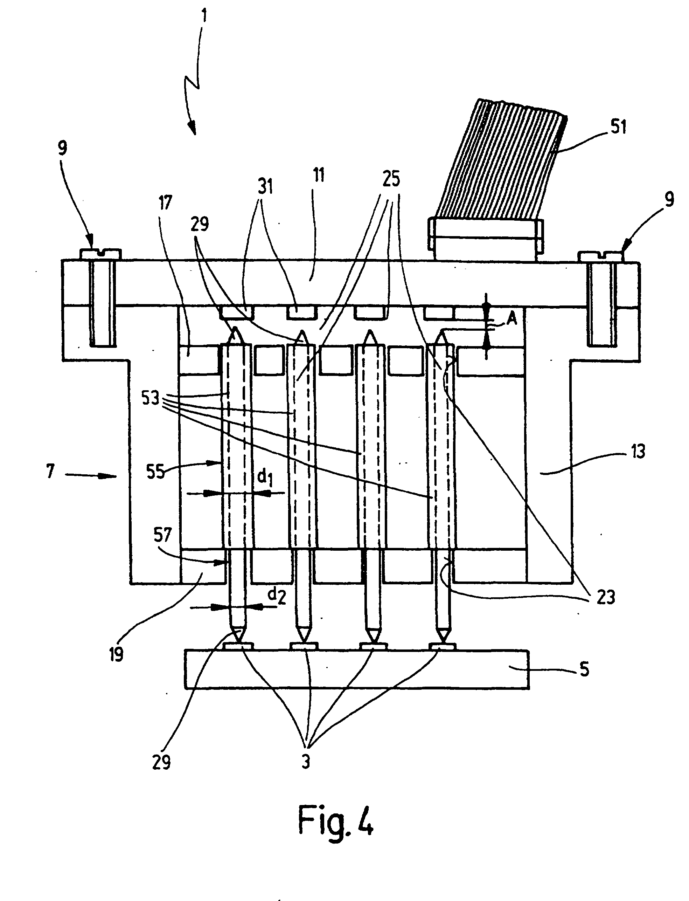

Figur 4 zeigt einen Ausschnitt eines weiteren Ausführungsbeispiels des erfindungsgemäßen Prüfkopfs 1, der eine Kontaktiervorrichtung 7 mit einem Grundkörper 13 umfaßt, an dem ein Verbindungselement 11 mittels Befestigungsmitteln 9 lösbar angebracht ist. Die an dem Verbindungselement 11 angebrachten Kontaktstellen 31 sind hier über ein Flachbandkabel 51 mit der Prüfeinrichtung verbunden. Die Kontaktiervorrichtung 7 umfaßt bei diesem Ausführungsbeispiel lediglich zwei Führungsplatten 17, 19, die parallel und in einem Abstand zueinander im Durchgangsloch 15 des Grundkörpers 13 befestigt sind. In den in den Führungsplatten 17, 19 eingebrachten Durchgangsöffnungen 23 sind Kontaktelemente 25 angeordnet, die in Längserstreckung abschnittsweise mit einer elektrisch isolierenden Schicht 53 versehen sind. Aufgrund der Isolierschicht 53 weisen die Kontaktelemente 25 einen ersten, durchmessergrößeren Abschnitt 55 und einen sich daran anschließenden zweiten, durchmesserkleineren Abschnitt 57 auf. Die Durchmesserdifferenz wird also durch die Isolierschicht 53 im Bereich des ersten Abschnitts 55 bewirkt. Die Kontaktelemente 25 sind mit ihrem zweiten, durchmesserkleineren Abschnitt 57 in der jeweils zugeordneten Durchgangsöffnung 23 der Führungsplatte 19 und mit ihrem durchmessergrößeren Abschnitt 55 in den Durchgangsöffnungen 23 der Führungsplatte 17 axial verschieblich geführt.

Der Durchmesser der in der Führungsplatte 19 eingebrachten Durchgangsöffnungen 23 ist kleiner als der Durchmesser der Kontaktelemente im Bereich ihres ersten Abschnitts 55. Dadurch wird sichergestellt, daß die Kontaktelemente 25 nicht in Richtung des Prüflings 5 -der Schwerkraft folgend- aus der Kontaktiervorrichtung 7 herausfallen können. Auf der .dem Prüfling 5 abgewandten Seite der Kontaktiervorrichtung 7 sind die Kontaktelemente 25 ebenfalls gegen ein Herausfallen gesichert, da dort das Durchgangsloch 15 im Grundkörper 13 mittels des lösbar an dem Grundkörper 13 angebrachten Verbindungselements 11 abgedeckt ist.

Der erste Abschnitt 55 weist einen Durchmesser d₁ und der zweite, durchmesserkleinere Abschnitt 57 einen Durchmesser d₂ auf, der hier dem Außendurchmesser der Kontaktelemente 25 entspricht. Wie aus Figur 4 ersichtlich, ist die Länge des ersten Abschnitts 55 so gewählt, daß im unbelasteten Zustand der Kontaktelemente 25, also beispielsweise zwischen zwei Prüfvorgängen, ein Spalt A zwischen den Kontaktspitzen 29 der Kontaktelemente 25 und den Kontaktstellen 31 am Verbindungselement 11 gegeben ist. Beim Aufsetzen des Prüfkopfs 1 auf den Prüfling oder umgekehrt, werden die Kontaktelemente 25 in axialer Richtung verschoben, bis die Kontaktspitzen 19 an den Kontaktstellen 31 anliegen. Durch die Druckbeaufschlagung der Kontaktelemente 25 können diese im Zwischenraum zwischen den Führungsplatten 17 und 19 quer zu ihrer Längserstreckung ausgelenkt werden, so daß die durch die elastische Eigenschaft des Materials erzeugten Rückstellkräfte die Kontaktspitzen der Kontaktelemente an die Prüfpunkte 3 und die Kontaktstellen 31 pressen.

Die Durchmesserdifferenz d₁-d₂ ist bei diesem Ausführungsbeispiel durch Abisolieren des zweiten Abschnitts 57 bewirkt. Das heißt, die Kontaktelemente 25 werden zunächst vollständig mit der Isolierschicht versehen, die anschließend im Bereich des zweiten Abschnitts 57 und an den Kontaktspitzen wieder entfernt wird. Es ist aber auch möglich, daß die Durchmesserdifferenz, also der gestufte Übergang vom ersten Abschnitt 55 der Kontaktelemente an den sich daran anschließenden zweiten Abschnitt 57 auch dadurch realisiert wird, daß von vornherein nur im Bereich des ersten Abschnitts 55 eine elektrisch isolierende Schicht aufgebracht wird. Die Isolierung wird also nur auf einer definierten Länge der Kontaktelemente aufgebracht, so daß die Herstellung der Kontaktelemente vereinfacht werden kann, da die Durchmesserdifferenz in einem Arbeitsschritt herstellbar ist.

Bei einer Ausführungsvariante des anhand der Figur 4 beschriebenen Ausführungsbeispiels des Prüfkopfs sind die jeweils einem Kontaktelement zugeordneten Durchgangsöffnungen 23 in den Führungsplatten 17, 19 derart versetzt zueinander angeordnet, daß die darin eingebrachten Kontaktelemente eine gebogene Form aufweisen. Dadurch wird die Knickkraft vollständig ausgeschaltet und eine Vorzugsrichtung vorgegeben, in welche die Kontaktelemente bei Druckbeaufschlagung an ihren Enden, zum Beispiel während eines Prüfvorgangs, ausgelenkt werden.

Allen anhand der Figuren 1 bis 4 beschriebenen Beispielen des Prüfkopfs 1 ist gemeinsam, daß die Kontaktelemente 25 in einfacher und somit kostengünstiger Weise mit Hilfe von Haltemitteln in oder an der Kontaktiervorrichtung 7 gehalten sind, so daß ein Herausgleiten der Kontaktelemente aus den Durchgangsöffnungen der Führungsplatten verhindert ist. Aufgrund der Ausgestaltung der Haltemittel, die zum Beispiel durch mindestens zwei Führungsplatten mit zueinander versetzt angeordneten Durchgangsöffnungen gebildet sind, in denen die Kontaktelemente reibschlüssig und vorgebogen verliersicher gehalten sind, können die Kontaktelemente besonders eng nebeneinander angeordnet werden, so daß auch Prüflinge mit einer engen Rasteranordnung der Prüfpunkte ohne weiteres geprüft werden können. Besonders vorteilhaft ist überdies, daß das Verbindungselement 11 und die Kontaktiervorrichtung 7 lösbar miteinander verbunden sind, wodurch eine gute Zugänglichkeit der im Durchgangsloch 15 des Grundkörpers 13 gehaltenen Kontaktelemente 25 von beiden Seiten des Durchgangslochs sichergestellt werden kann. Des weiteren kann ein Auswechseln einzelner Kontaktelemente -je nach Ausführungsvariante der Kontaktelemente- von beiden Seiten des Durchgangslochs 15 möglich sein.

Durch die zerstörungsfreie und einfache Trennbarkeit des Verbindungselements und der Kontaktiervorrichtung ist ein schneller Austausch eines der Teile möglich. Ferner kann der Prüfkopf zum Prüfen von mehreren, eine unterschiedliche Rasteranordnung der Prüfpunkte aufweisende Ausführungsformen von Prüflingen eingesetzt werden. Hierzu muß lediglich das Kontaktierelement durch ein entsprechend anders ausgestaltetes Kontaktierelement ausgetauscht werden.

## Patentansprüche

1. Prüfkopf (1) mit einer mehrere Kontaktelemente (25) aufweisenden Kontaktiervorrichtung (7) zum Kontaktieren von vorzugsweise eng nebeneinander angeordneten Prüfpunkten (3) eines elektrischen Prüflings (5), wobei die Kontaktelemente (25) mit einem Verbindungselement (11) elektrisch kontaktierbar sind und in Durchgängsöffnungen (23) einer mindestens zwei Führungsplatten (17,19) aufweisenden Führung angeordnet sind, wobei ein Ende (28) jedes Kontaktelements (25) jeweils auf eine Kontaktstelle (31) des Verbindungselements (11) gerichtet und das andere Ende (27) jedes Kontaktelements (25) jeweils auf einen Prüfpunkt (3) des Prüflings (5) richtbar ist und die Kontaktelemente (25) zu deren Sicherung gegen Herausfallen aus den Durchgangsöffnungen (23) jeweils einen ersten, durchmessergrößeren Abschnitt (55) und einen sich daran anschließenden durchmesserkleineren, zweiten Abschnitt (57) aufweisen und mit ihrem durchmessergrößeren Abschnitt (55) in der zugeordneten Durchgangsöffnung (23) der einen Führungsplatte (17) der Führung und mit ihrem durchmesserkleineren Abschnitt (57) in der zugeordneten Durchgangsöffnung (23) der anderen Führungsplatte (19) der Führung axial verschieblich geführt sind, wobei der Durchmesser der Durchgangsöffnung (23), in der das jeweilige Kontaktelement (25) mit seinem zweiten Abschnitt (57) axial verschieblich geführt ist, kleiner ist als der Außendurchmesser (d1) des ersten Abschnitts, (55) **dadurch gekennzeichnet, daß** die Durchmesserdifferenz (d1-d2) zwischen dem ersten und zweiten Abschnitt (55,57) jedes Kontaktelements (25) durch eine elektrisch isolierende Schicht (53) im Bereich des ersten Abschnitts (55) bewirkt ist und daβ die Kontaktiervorrichtung (7) an dem Verbindungselement (11) lösbar befestigt ist.

2. Prüfkopf nach Anspruch 1, **dadurch gekennzeichnet, daß** jedes Kontaktelement in der jeweils zugeordneten Durchgangsöffnung (23;47) reibschlüssig gehalten ist.

3. Prüfkopf nach Anspruch 1 oder 2, **dadurch gekennzeichnet, daß** die Kontaktelemente aus einem elektrisch leitenden Material bestehen (25).

4. Prüfkopf nach einem der vorhergehenden Ansprüche, **dadurch gekennzeichnet, daß** die Durchmesserdifferenz (d₁-d₂) durch Abisolieren des zweiten Abschnitts (57) gebildet ist.

5. Prüfkopf nach einem der vorhergehenden Ansprüche 1-3 **dadurch gekennzeichnet, daß** die Durchmesserdifferenz (d₁-d₂) durch das Aufbringen der elektrischen Isolierschicht (53) im Bereich des ersten Abschnitts (55) bewirkt ist.

6. Prüfkopf nach einem der vorhergehenden Ansprüche, **dadurch gekennzeichnet, daß** die jeweils einem Kontaktelement (25) zugeordneten Durchgangsöffnungen (23) der Führungsplatten (17,19) derart versetzt zueinander angeordnet sind, daß das Kontaktelement (25) in ihnen oder mindestens einer von ihnen reibschlüssig gehalten ist.

7. Prüfkopf nach einem der vorhergehenden Ansprüche, **gekennzeichnet dadurch, daß** die Führung eine dritte Führungsplatte aufweist (21), die im Zwischenraum Zwischen der ersten Führungsplatte (17) und der zweiten Führungsplatte (19) angeordnet ist, wobei mindestens eine der einem Kontaktelement (25) zugeordneten Durchgangsöffnungen (23) zu den anderen Durchgangsöffnungen (23) in den anderen Führungsplatten versetzt ist.

8. Prüfkopf nach einem der vorhergehenden Ansprüche, **dadurch gekennzeichnet, daß** die jeweils einem Kontaktelement (25) zugeordneten Durchgangsöffnungen (23) der ersten und zweiten Führungsplatte (17,19) fluchtend angeordnet sind und daß die zugeordnete Durchgangsöffnung (23) in der dritten Führungsplatte (21) zu den Durchgangsöffnungen (23) der anderen Führungsplatten (17,19) versetzt ist.

9. Prüfkopf nach einem der vorhergehenden Ansprüche, **dadurch gekennzeichnet, daß** jedes Kontaktelement (25) aus einem elastischen, vorzugsweise federelastischen Material besteht.

10. Prüfkopf nach einem der vorhergehenden Ansprüche, **dadurch gekennzeichnet, daß** die Kontaktelemente (25) als Knickdrähte ausgebildet sind.

11. Prüfkopf nach einem der vorhergehenden Ansprüche, **dadurch gekennzeichnet, daß** das den Prüfpunkten (3) zugewandte und/oder abgewandte freie Ende der Kontaktelemente (25) eine Kontaktspitze (29) aufweissen aufweist.

12. Prüfkopf nach einem der vorhergehenden Ansprüche, **dadurch gekennzeichnet, daß** das den Prüfpunkten (3) zugewandte Ende (27) der Kontaktelemente (25) an den jeweils zugeordneten Prüfpunkt (3) andrückbar ist.

13. Prüfkopf nach einem der vorhergehenden Ansprüche, **dadurch gekennzeichnet, daß** das den Prüfpunkten (3) abgewandte freie Ende (28) der Kontaktelemente (25) zur Herstellung des elektrischen Kontakts mit der Prüfeinrichtung an jeweils eine zugeordnete Kontaktstelle (31) andrückbar ist.

14. Prüfkopf nach einem der vorhergehenden Ansprüche, **dadurch gekennzeichnet, daß** die Kontaktstelle (31) am Verbindungselement (11) angebracht ist.

15. Prüfkopf nach einem der vorhergehenden Ansprüche, **dadurch gekennzeichnet, daß** die Kontaktstelle (31) mit dem freien Ende einer Leitung (35) verbunden ist, die zur Prüfeinrichtung führt.

16. Prüfkopf nach einem der vorhergehenden Ansprüche, **dadurch gekennzeichnet, daß** die Kontaktelemente in Durchgangsöffnungen (47) einer Haltefolie (45) oder Elastomerschicht reibschlüssig gehalten sind.

17. Prüfkopf nach Anspruch 16, **dadurch gekennzeichnet, daß** die Haltefolie (45) oder Elastomerschicht zwischen zwei Führungsplatten (17,21) vorgesehen ist.

18. Prüfkopf nach Anspruch 16 oder 17, **dadurch gekennzeichnet, daß** die Haltefolie (45) oder Elastomerschicht an mindestens einer der Führungsplatten (17,19,21) angebracht ist.

19. Prüfkopf nach Anspruch 4, **dadurch gekennzeichnet, daß** die Führung in einem Durchgangsloch (15) eines Grundkörpers (13) angeordnet ist, wobei zwischen der dem Prüfling (5) abgewandten Seite der Führung, dem Verbindungselement (11) sowie der Wandung des Durchgangslochs (15) ein zumindest bereichsweise geschlossener Raum begrenzt ist, und daß erste Abschnitt (55) der Kontaktelemente (25) in diesem Raum angeordnet ist.

## Claims

1. Test head (1) with a contacting arrangement (7) comprising several contact elements (25) for the contacting of preferably closely adjacent positioned test points (3) of an electrical test piece (5), whereby the contact elements (25) are electrically contactable with a connection element (11), and whereby the same are positioned within the passage openings (23) of a guide that comprises two guide plates (17, 19), whereby an end (28) of each contact element (25) is directed towards a contact point (31) of the connection element (11), and whereby the other end (27) of each contact element (25) can be directed towards a test point (3) of the test piece (5), and whereby the contact elements (25), for securing them against dropping out of the passage openings 23, each comprise a first section (55) of a larger sized diameter and a subsequent second section (57) with a smaller sized diameter, and whereby the section (55) with the larger sized diameter is slideably and axially guided within the corresponding passage opening (23) of a guide plate (17) of the guide and the section (57) with the smaller sized diameter is slideably and axially guided within the corresponding passage opening (23) of the other guide plate (19) of the guide, whereby the diameter of the passage opening (23) in which the relevant contact element (25) with its second section (57) is axially and slideably guided, whereby the same is smaller than the external diameter (d₁) of the first section (55), **characterised in that** the diameter difference (d₁-d₂) between the first and the second section (55, 57) of each contact element (25) is build by an electrically isolating layer (53) within the area of the first section (55), and **in that** the contacting arrangement (7) is disconnectably affixed to the connection element (11).

2. Test head according to claim 1, **characterised in that** each contact element is held in a friction engaging manner within the corresponding passage opening (23; 47).

3. Test head according to claim 1 or 2, **characterised in that** the contact elements (25) consist of an electrically conductive material.

4. Test head according to one of the preceding claims, **characterised in that** the diameter difference (d₁-d₂) is formed by stripping the isolating of the second section (57).

5. Test head according to one of the preceding claims 1-3, **characterised in that** the diameter difference (d₁-d₂) is created through the applying of the electrical isolating layer (53) within the area of the first section (55).

6. Test head according to one of the preceding claims, **characterised in that** the passage openings (23) of the guide plates (17, 19) each allocated to a contact element (25), are offset from one another in such a way that the contact element (25) is held within the same, or at least within one of them in a friction engaging manner.

7. Test head according to one of the preceding claims, **characterised in that** the guide comprises a third guide plate (21), which is positioned within the interim space between the first guide plate (17) and the second guide plate (19), whereby at least one of the passage openings (23) allocated to the contact element (25) is offset in relation to the other passage openings (23) in the other guide plates.

8. Test head according to one of the preceding claims, **characterised in that** the passage openings (23) of the first and second guide plate (17, 19) which are each allocated to one contact element (25) are aligned, and **in that** the corresponding passage opening (23) within the third guide plate (21) is offset from the passage openings (23) of the other guide plates (17, 19).

9. Test head according to one of the preceding claims, **characterised in that** each contact element (25) consists of an elastic, preferably spring elastic material.

10. Test head according to one of the preceding claims, **characterised in that** the contact elements (25) take the form of downturned wires.

11. Test head according to one of the preceding claims, **characterised in that** the free end of the contact elements (25) that is directed towards and/or is facing away from the test points (3) comprises a contact tip (29).

12. Test head according to one of the preceding claims, **characterised in that** the end (27) of the contact elements (25) that is directed towards the test points (3) can be pressed against the corresponding test point (3).

13. Test head according to one of the preceding claims, **characterised in that** the free end (28) of the contact elements (25) that is facing away from the test points (3) can be pressed against the corresponding contact point (31) for the creation of the electrical contact with the test apparatus.

14. Test head according to one of the preceding claims, **characterised in that** the contact point (31) is affixed to the connection element (11).

15. Test head according to one of the preceding claims, **characterised in that** the contact point (31) is connected with the free end of a line (35) that leads to the test apparatus.

16. Test head according to one of the preceding claims, **characterised in that** the contact elements are held in a friction engaging manner within passage openings (47) in a holding foil (45) or within an elastomer layer.

17. Test head according to laim 16, **characterised in that** the holding foil (45) or the elastomer layer is provided between two guide plates (17, 21).

18. Test head according to claim 16 or 17, **characterised in that** the holding foil (45) or the elastomer layer is affixed to at least one guide plate (17, 19, 21).

19. Test head according to claim 4, **characterised in that** the guide is positioned within a through hole (15) of a base body (13), whereby an at least partially enclosed space is bounded between the side of the guide that faces away from the test piece (5) and the connection element (11) as well as the wall of the through hole (15), and **in that** the first section (55) of the contact elements (25) is located within this space.

## Revendications

1. Tête de sonde (1) avec un dispositif d'établissement de contact (7) présentant plusieurs éléments de contact (25) pour établir le contact de points de contrôle (3) d'une éprouvette électrique (5), disposés de préférence proches les uns des autres, les éléments de contact (25) pouvant être mis en contact électriquement avec un élément de liaison (11) et étant disposés dans des orifices de passage (23) d'un guidage présentant au moins deux plaques de guidage (17, 19), une extrémité (28) de chaque élément de contact (25) étant dirigée vers un point de contact (31) de l'élément de liaison (11) et l'autre extrémité (27) de chaque élément de contact (25) pouvant être dirigée vers un point de contrôle (3) de l'éprouvette (5) et les éléments de contact (25) présentant, afin d'empêcher qu'ils ne sortent des orifices de passage (23), un premier segment de diamètre plus grand (55) et un deuxième segment de diamètre plus petit (57) faisant suite au premier et étant guidés de manière mobile dans le sens axial avec leur segment de diamètre le plus grand (55) dans l'orifice de passage (23) correspondant d'une plaque de guidage (17) du guidage et avec leur segment de diamètre plus petit (57) dans l'orifice de passage correspondant (23) de l'autre plaque de guidage (19) du guidage, le diamètre de l'orifice de passage (23), dans lequel chaque élément de contact (25) est guidé de façon mobile dans le sens axial avec son deuxième segment (57), étant plus petit que le diamètre extérieur (d₁) du premier segment (55), tête de sonde **caractérisée en ce que** la différence de diamètre (d₁ - d₂) entre le premier et le deuxième segment (55, 57) de chaque élément de contact (25) est due à une couche isolante électriquement (53) dans la région du premier segment (55) et **en ce que** le dispositif d'établissement de contact (7) est fixé de manière séparable sur l'élément de liaison (11).

2. Tête de sonde selon la revendication 1, **caractérisé en ce que** chaque élément de contact est maintenu de manière solidaire par friction dans l'orifice de passage correspondant (23, 47).

3. Tête de sonde selon la revendication 1 ou 2, **caractérisé en ce que** les éléments de contact (25) sont réalisés dans un matériau conduisant l'électricité.

4. Tête de sonde selon l'une quelconque des revendications précédentes, **caractérisé en ce que** la différence de diamètre (d₁ - d₂) est due à ce que le deuxième segment (57) est dénudé.

5. Tête de sonde selon l'une quelconque des revendications 1 à 3, **caractérisé en ce que** la différence de diamètre (d₁ - d₂) est due à la pose ou le montage de la couche isolante électriquement (53) dans la région du premier segment (55).

6. Tête de sonde selon l'une quelconque des revendications précédentes, **caractérisé en ce que** les orifices de passage (23) des plaques de guidage (17, 19) associés chacun à un élément de contact (25) sont disposés de manière décalée les uns par rapport aux autres, de façon que l'élément de contact (25) soit maintenu dans ceux-ci ou au moins dans l'un de ceux-ci de manière solidaire par friction.

7. Tête de sonde selon l'une quelconque des revendications précédentes, **caractérisé en ce que** le guidage présente une troisième plaque de guidage (21) qui est disposée dans l'espace intermédiaire entre la première plaque de guidage (17) et la deuxième plaque de guidage (19), au moins l'un des orifices de passage (23) associé à un élément de contact (25) étant décalé par rapport aux autres orifices de passage (23) se trouvant dans les autres plaques de guidage.

8. Tête de sonde selon l'une quelconque des revendications précédentes, **caractérisé en ce que** les orifices de passage (23) de la première et de la deuxième plaque de guidage (17, 19) associés à un élément de contact (25) sont disposés alignés et que l'orifice de passage associé (23) dans la troisième plaque de guidage (21) est décalé par rapport aux orifices de passage (23) se trouvant dans les autres plaques de guidage (17, 19).

9. Tête de sonde selon l'une quelconque des revendications précédentes, **caractérisé en ce que** chaque élément de contact (25) est réalisé dans un matériau élastique, de préférence, qui fait ressort.

10. Tête de sonde selon l'une quelconque des revendications précédentes, **caractérisée en ce que** les éléments de contact (25) sont formés comme des fils métalliques coudés.

11. Tête de sonde selon l'une quelconque des revendications précédentes, **caractérisée en ce que** l'extrémité libre des éléments de contact (25) tournée vers les points de contrôle (3) et/ou opposée à ceux-ci présente(nt) une pointe de contact (29).

12. Tête de sonde selon l'une quelconque des revendications précédentes, **caractérisée en ce que** l'extrémité (27) des éléments de contact (25) tournée vers les points de contrôle (3) peut être appliquée par pression sur le point de contrôle (3) correspondant.

13. Tête de sonde selon l'une quelconque des revendications précédentes, **caractérisée en ce que** l'extrémité libre (28) des éléments de contact (25) opposée aux points de contrôle (3) peut être appliquée par pression sur un point de contact (31) correspondant pour établir le contact électrique avec le dispositif de contrôle.

14. Tête de sonde selon l'une quelconque des revendications précédentes, **caractérisée en ce que** le point de contact (31) est monté sur l'élément de liaison (11).

15. Tête de sonde selon l'une quelconque des revendications précédentes, **caractérisée en ce que** le point de contact (31) est relié à l'extrémité libre d'une ligne (35) qui conduit au dispositif de contrôle.

16. Tête de sonde selon l'une quelconque des revendications précédentes, **caractérisée en ce que** les éléments de contact sont maintenus de manière solidaire par friction dans des orifices de passage (47) d'un film de retenue (45) ou d'une couche d'élastomère.

17. Tête de sonde selon la revendication 16, **caractérisée en ce que** le film de retenue (45) ou la couche d'élastomère est prévue entre deux plaques de guidage (17, 21).

18. Tête de sonde selon la revendication 16 ou 17, **caractérisée en ce que** le film de retenue (45) ou la couche d'élastomère est montée sur au moins l'une des plaques de guidage (17,19, 21).

19. Tête de sonde selon la revendication 4, **caractérisée en ce que** le guidage est disposé dans un trou de passage (15) d'un corps de base (13), un espace fermé au moins en partie étant délimité entre la face du guidage opposée à l'éprouvette, l'élément de liaison (11) ainsi que la paroi du trou de passage (15), et le premier segment (55) des éléments de contact (25) étant disposé dans cet espace.
